# EUROPEAN PATENT APPLICATION

(11) **EP 1 813 863 A1**
(43) Date of publication of application: **01.08.2007**
(21) Application number: 05802018.1
(22) Date of filing: 28.10.2005
(51) Int. Cl.: F21V 29/00

(54) **A HEAT-DISPERSING STRUCTURE FOR THE LEDs LAMP**

(30) Priority: 09.11.2004 CN 200410052114
(71) Applicant: Li, Xuelin, Zhuhai, Guangdong 519000 (CN)
(72) Inventor: Li, Xuelin, Zhuhai, Guangdong 519000 (CN)
(74) Representative: Vigars, Christopher Ian
(86) International application number: PCT/CN2005/001794
(87) International publication number: WO 2006/050656

(57) **Abstract**

A heat dissipating structure of LED lamp includes a circuit driving board having LEDs array and a circuit controlling board; a heat-dissipating and light-reflecting aluminum sheet is provided on the upside of the circuit driving board, a heat-dissipating glue layer is attached to the underside of the circuit driving board, and a heat-dissipating aluminum sheet is attached to the other side of the heat dissipating glue layer.The said circuit controlling board can be wrapped with heat dissipating glue, so that the heat being produced during the operation of the line control board can be further dissipated.

## Description

### Technical field of this invention

This invention relates to LED lamp, especially to the heat dissipating structure of LED lamp.

### Prior Art

As a kind of light source, LED features low energy consuming, low heat producing, and long life servicing, so that it has been widely used in lighting and decorative lights. However, single LED emits insufficient light, so it is necessary to adopt LED array to increase the overall brightness of LED lamp. Although LED produces a very small amount of heat, a number of LEDs in a relatively closed lamp produce certain amount of heat, which is hard to dissipate but accumulates. Therefore, it is necessary to think about the impact of the accumulated heat. On the basis of the current LED technology, LED may bum and be scrapped once its working temperature is over 80°C. As a result, the using effect and quality of LED lamp will be affected. At present, there is no effective measure for resolving the problems on LED heating.

### Purpose of this invention

The purpose of this invention is to resolve the said problem, and provide a simple LED heat dissipating structure, which can effectively resolve the heat dissipating problem during the operation of LED lamp.

### Technical solution of this invention

To achieve the said purpose, this invention adopts the following technical solution. A heat dissipating structure of LED lamp includes a circuit driving board having LEDs array and a circuit controlling board; a heat-dissipating and light-reflecting aluminum sheet is provided on the upside of the circuit driving board, a heat-dissipating glue layer is attached to the underside of the circuit driving board, and a heat-dissipating aluminum sheet is attached to the other side of the heat dissipating glue layer.

The said circuit controlling board is wrapped with heat dissipating glue, so that the heat being produced during the operation of the line control board can be further dissipated.

The said heat dissipating glue layer is made of rubber/silica gel and mica powder, and the weight proportion of latex/silica gel and mica powder is 1:0.05~1.

Due to the said sandwich structure, this invention enables the heat, which is produced during the LED's operation, to dissipate through different layers quickly and effectively, keeping the working temperature of LED below 65°C. Thus, the problem on LED lamp's heat dissipating is resolved.

### BRIEV DESCRIPTION OF THE DRAWINGS

Fig. 1 shows the structure of this invention;
Fig 2 shows the decomposed structure of this invention.

In the following embodiment, this invention will be further described with the drawings.

### EMBODIMENT

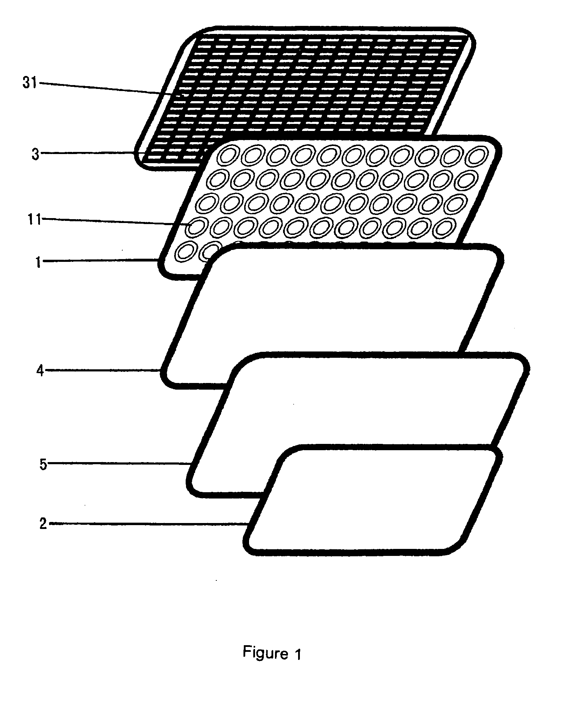

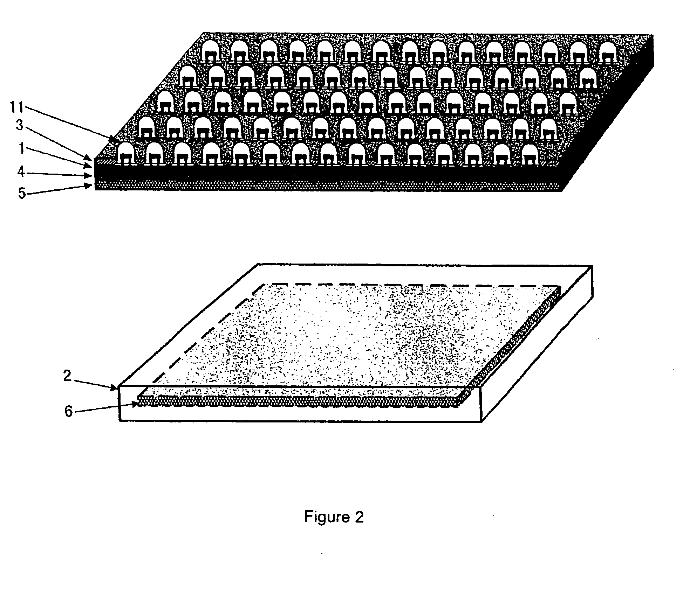

Referring to fig. 1 and fig.2, this invention includes a circuit driving board 1 and a circuit controlling board 2. A LED array 11 is integrated on the circuit driving board 1. A heat-dissipating and light-reflecting aluminum sheet 3 is attached on the upside of the circuit driving board 1. The said heat-dissipating and light-reflecting aluminum has holding holes 31, whose quantity is the same as the quantity of the LEDs, so that the LEDs can protrude out of the holding holes 31. A heat-dissipating glue layer 4 is attached to the underside of the circuit driving board 1, and a heat-dissipating aluminum sheet 5 is attached to the other side of the heat dissipating glue layer. The circuit controlling board 2 is wrapped with heat dissipating glue.

The said heat dissipating glue layer is made of latex/silica gel and mica powder. And according to different requirements, the weight proportion of latex/silica gel and mica powder can be 1:0.05~1.

The said heat dissipating glue layer is 2mm-20mm thick to achieve the best effect of heat dissipating.

According to the invention, when the LED lamp works, the heat produced by LED's body is radiated through the heat-dissipating and light-reflecting aluminum sheet, while the heat produced by the LED's feet is dissipated through the heat dissipating glue layer 4 and the heat dissipating aluminum sheet 5. Therefore, all of the heat produced by LEDs is effectively and quickly dissipated, so that the working temperature of LEDs is always kept below 65°C. The circuit controlling board 2 is wrapped with heat dissipating glue 6, so that the heat being produced during the operation of the circuit controlling board 2 can be further dissipated.

## Claims

1. A heat dissipating structure of LED lamp including a circuit driving board having LEDs array and a circuit controlling board, wherein
a heat-dissipating and light-reflecting aluminum sheet being provided on the upside of the circuit driving board, and
a heat-dissipating glue layer being attached to the underside of the circuit driving board, and
a heat-dissipating aluminum sheet being attached to the other side of the heat dissipating glue layer.

2. The heat dissipating structure of LED lamp according to claim 1, wherein the said circuit controlling board is wrapped with heat dissipating glue.

3. The heat dissipation structure of LED lamp according to claim 1 or claim 2 wherein the said heat dissipating glue layer is made of rubber/silica gel and mica powder.

4. The heat dissipation structure of LED lamp according to claim 3 wherein the weight proportion of latex/silica gel and mica powder is 1:0.05~1.

5. The heat dissipation structure of LED lamp according to claim 1 wherein the said heat dissipating glue layer is 2mm-20mm thick.
